# EUROPÄISCHE PATENTSCHRIFT

(11) **EP 2 808 852 B1**
(45) Veröffentlichungstag und Bekanntmachung des Hinweises auf die Patenterteilung: **29.06.2016**
(21) Anmeldenummer: 14168516.4
(22) Anmeldetag: 15.05.2014
(51) Int. Cl.: G08C 17/00, H01M 2/10

(54) **Fernsteuerung**
Remote control
Télécommande

(30) Priorität: 27.05.2013 DE 102013008891
(43) Veröffentlichungstag der Anmeldung: 03.12.2014
(60) Teilanmeldung: 15001476.9
(73) Patentinhaber: fm marketing gmbh, 5202 Neumarkt am Wallersee (AT)
(72) Erfinder: Ibrahimovic, Semsudin, 5202 Neumarkt am Wallersee (AT); Maier, Ferdinand, 5202 Neumarkt am Wallersee (AT)
(74) Vertreter: von Bülow & Tamada

(56) Entgegenhaltungen:
- WO-A1-97/40653
- US-A1- 2004 196 621

## Beschreibung

Die Erfindung bezieht sich auf eine Fernsteuerung gemäß dem Oberbegriff des Patentanspruches 1.

Solche Fernsteuerungen werden meist alls drahtlose Fernsteuerungen für die Steuerung elektronischer Geräte, wie z.B. Fernsehgeräte, Settopboxen, Videorecorder und sonstige Geräte für Heimunterhaltung verwendet. Die Fernsteuerungen haben üblicherweise ein Gehäuse, in das eine "Elektronik" mit Leiterbahnplatte und Tastatur eingesetzt ist sowie eine oder mehrere Batterien, die in ein öffenbares Batteriefach des Gehäuses eingesetzt sind. Zum Auswechseln der Batterien muss das Batteriefach geöffnet werden, was meist durch Abnehmen eines Batteriefachdeckels erfolg. Zur Halterung des Batteriefachdeckels werden häufig Rastfedern verwendet, die hinter eine stegförmige Rastkante eingreifen, wobei die Rastfeder durch einen Aushebeansatz oder elastische Verformung des Batteriefachdeckels so weit verbogen wird, dass der Batteriefachdeckel abgenommen werden kann.

Solche Konstruktionen sind aus der DE 30 35 669 A1, DE 36 03 915 A1, DE 84 01 563 U1, DE 196 42 517 C2 bekannt, wobei bei letzterer die Verriegelungsfeder durch Einführen eines dünnen Stiftes durch eine Gehäusebohrung in eine Öffnungsstellung gebracht werden kann.

Ähnliche Gehäuseverriegelungen mit Rastfeder sind auch aus der DE 199 29 083 C1, DE 29 72 198 U1, GB 13 26 592 A, US 832284 A1, US 5691878 A1, US 6004690 A1, US 6997635 B2 und WO 87/02859 A1 bekannt.

Bei vielen elektronischen Geräten, wie auch bei Fernsteuerungen werden die für die Stromversorgung benötigten Batterien in einem Batterieträger angeordnet, der ein eigenes ganz oder teilweise geschlossenes Gehäuse hat, wie aus der DE 31 03 534 C2 bekannt. Ähnliche Batteriefächer sind auch aus der DE 29519209 U1, DE 10 2007 057 971 A1 und DE 20 2004 006 280 U1 bekannt.

Die Druckschrift US 2004/196621 A1 offenbart eine Fernsteuerung gemäß den Oberbegriff des geltenden Anspruchs 1.

Aufgabe der Erfindung ist es, eine Fernsteuerung zu schaffen, die ein kompaktes Gehäuse hat, das sich auch bei stärkeren Stößen, wie z.B. einem Herunterfallen, nicht öffnet, das einerseits einen Batteriewechsel in einfacher Weise ermöglicht, andererseits aber den Batteriewechsel aber wiederum so erschwert, dass uninformierte Benutzer nicht oder nur mit Mühe an die Batterien herankommen, um ein unauthorisiertes Entfernen der Batterien zu vermeiden.

Diese Aufgabe wird durch die im Patentanspruch 1 angegebenen Merkmale gelöst. Vorteilhafte Ausgestaltungen und Weiterbildungen der Erfindung sind den Unteransprüchen zu entnehmen.

Die Fernsteuerung nach der Erfindung hat ein einstükkiges Gehäuse mit einer Batterieaufnahme in Form einer Sacklochausnehmung, die gegenüber einem als Elektronikaufnahme bezeichneten Gehäuseteil unter einem stumpfen Winkel abgeknickt ist. Die gesamte Elektronik ist gegenüber dem Gehäuse linear verschiebbar und zwar mindestens so weit, dass ein Batterieträger aus der Sacklochausnehmung herausgezogen werden kann. Zur Fixierung der Elektronik in dem Gehäuse ist eine spezielle Verriegelungsfeder vorgegehen, die zwischen einer Leiterbahnplatte der Elektronik und einem Elektronikträger eingesetzt ist und mit einem Federarm durch eine Öffnung des Elektronikträgers hindurchgreift und sich am Boden des Gehäuses abstützt, wo sie zur Fixierung hinter eine Rastkante eingreift. Im Boden des Gehäuses ist eine kleine Öffnung mit einem Durchmesser in der Größenordnung einer Büroklammer oder einer Nähnadel angebracht, die gegenüberliegend zu dem Federarm der Rastfeder angeordnet ist. Weiter ist im Boden des Gehäuses eine zu der genannten Rastkante hin ansteigende Rampe vorgegehen, längs der die Rastfeder gleitet.

Um ein vollständiges Herausziehen der gesamten Elektronik aus dem Gehäuse zu verhindern, ist an dem Elektronikträger eine weitere Feder angebracht, die beim Herausziehen gegen die genannte Rastkante zum Anschlag kommt.

Der Batterieträger ist im Boden der Sacklochausnehmung durch Federn abgestützt. An seinem gegenüberliegenden Ende hat er eine weitere Rastfeder, die an eine Rastkante eingreift und so den Batterieträger hält. Der Batterieträger hat Kontaktarme, die gegen Kontaktflächen am Elektronikträger bzw. der Leiterbahnplatte drücken und zwar in einer Richtung, die senkrecht zur Ebene der Leiterbahnplatte steht. Damit wird erreicht, dass bei eingesetztem Batterieträger und eingesetzter Elektronik keine Kräfte in Verschieberichtung auftreten und somit die Kontaktkraft konstant ist, auch wenn der Batterieträger und die Elektronik in gewissem Umfang federelastisch gelagert sind.

Im Folgenden wird die Erfindung anhand eines Ausführungsbeispieles im Zusammenhang mit der Zeichnung ausführlicher erläutert.

Es zeigt:
- Fig. 1: eine Explosionsdarstellung der Fernsteuerung nach der Erfindung;
- Fig. 2: eine perspektivische Ansicht des Gehäuses der Fernsteuerung;
- Fig. 3: einen Längsschnitt des Gehäuses der Fernsteuerung;
- Fig. 4: eine perspektivische Ansicht einer Verriegelungsfeder; und
- Fig. 5: eine perspektivische Ansieht eines Batterieträgers.

Die Fernsteuerung hat folgende Grundkomponenten: ein Gehäuse 1, eine Leiterbahnplatte 2, die die gesamt benötigte Elektronik einschließlich Tastatur enthält, einen Elektronikträger 3, einen Batterieträger 4 und eine Verriegelungsfeder 5.

Das Gehäuse 1 ist ein einstückiger Körper aus Aluminium, der eine Sacklochausnehmung 6 aufweist, in die der Batterieträger eingesetzt werden kann. Die Leiterbahnplatte 2 ist in den Elektronikträger einsetzbar und dort mit mehreren Schrauben 7 befestigt. Der Elektronikträger 3 kann zusammen mit der an ihm befestigten Leiterbahnplatte in das Gehäuse 1 eingeschoben werden und teilweise oder ganz zum Wechseln der Batterien in dem Batterieträger linear längs des Gehäuses 1 verschoben werden, wobei der Teil des Gehäuses 1, der die Sacklochbohrung aufweist, als Batterieteil 8 bezeichnet wird und gegenüber einem als Elektronikaufnahme 9 bezeichneten Gehäuseteil unter einem stumpfen Winkel α abgeknickt ist, wobei dieser Winkel in der Größenordnung von 175 Grad liegt.

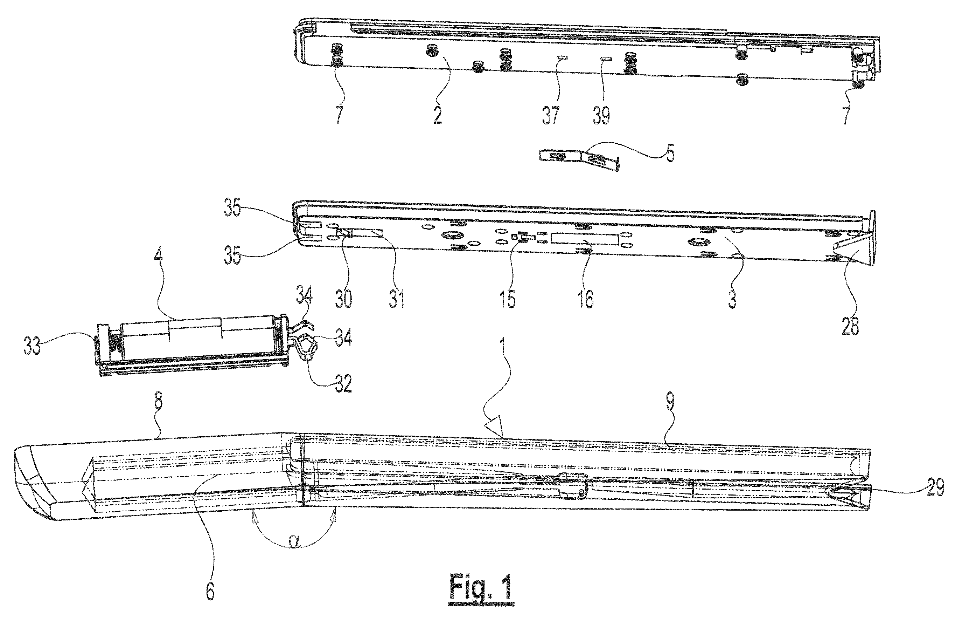

Zum Auswechseln der Batterien muss der Elektronikträger 3 samt Leiterbahnplatte 2 teilweise aus der Elektronikaufnahme 9 (nach rechts in Figur 1) so weit verschoben werden, dass der Batterieträger 4 aus dem Batterieteil 8 bzw. der Sacklochausnehmung 6 herausgeschoben und entnommen werden kann.

Andererseits soll im normalen Betriebszustand bei eingesetzten Batterien die Elektronik, bestehend aus Elektronikträger 3 und Leiterbahnplatte 2, fest im Gehäuse 1 gehalten sein und bei härteren Stößen wie z.B. bei einem Herunterfallen der Fernsteuerung sich nicht lösen. Weiter soll ein Batteriewechsel einerseits mögliehst einfach durchgeführt werden können, andererseits jedoch für uninformierte Laien erschwert sein, um beispielsweise in Hotels den immer häufiger vorkommenden Diebstahl von Batterien aus Fernbedienungen zu erschweren.

Zu diesem Zweck erfolgt die Befestigung des Elektronikteils durch eine spezielle Verriegelungsfeder 5 und eine spezielle Ausformung des Gehäuses 1 und des Elektronikträgers 3.

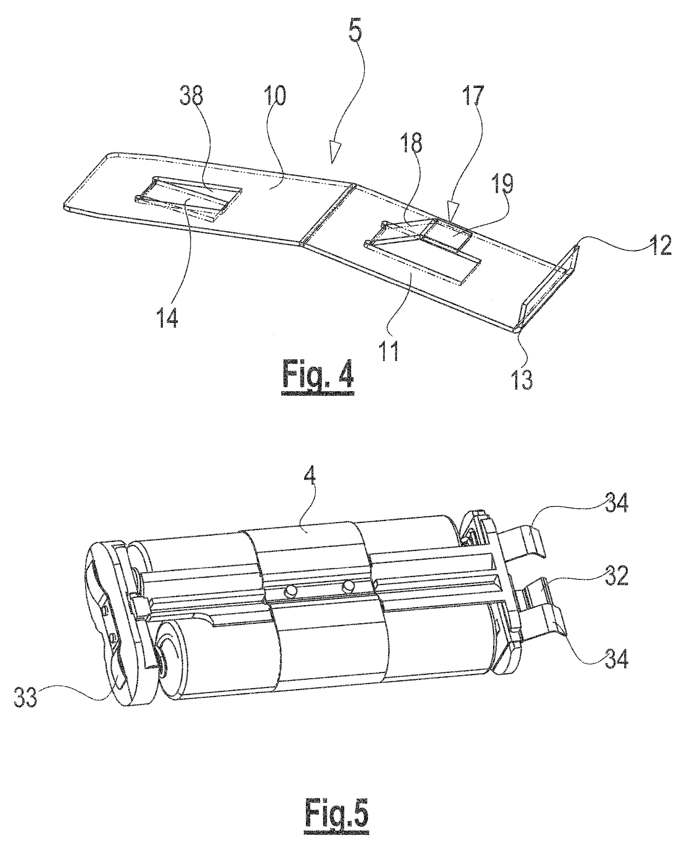

Die Verriegelungsfeder 5 ist in Figur 4 detaillierter dargestellt. Sie hat einen ersten horizontalen Halteschenkel 10, der zwischen der Leiterbahnplatte 2 und dem Elektronikträger 3 eingespannt ist und einen Federschenkel 11, an dessen freiem Ende ein Rastschenkel 12 in etwa rechtwinklig absteht, wobei im Übergangsbereich zwischen dem Federschenkel 11 und dem Rastschenkel 12 eine Abrundung 13 vorgesehen ist.

Im mittleren Bereich des Halteschenkels 10 ist ein Haltearm 14 vorgegehen, der im eingesetzten Zustand in eine Ausnehmung 15 des Elektronikträgers eingreift und damit die Verriegelungsfeder 5 positioniert und gegen Verschieben in der Ebene der Leiterbahnplatte 2 hält.

Weiter ist an der zum Elektronikträger 3 weisenden Unterseite der Leiterbahnplatte 2 ein vorspringender Pfosten 37 angebracht, der in eine von dem Haltearm 14 durch dessen teilweises Ausstanzen und Herausbiegen entstandene Öffnung 38 eingreift, wodurch die Verriegelungsfeder 5 gegen ein Verschieben gesichert ist. Weiter kann an der Leiterbahnplatte 2 ein zusätzlicher in Richtung zur dem Elektronikträger 3 weisender Pfosten 39 vorgesehen sein, an den sich der Kontaktschenkel 19 der Verriegelungsfeder 5 abstützt.

Der gegenüber dem Halteschenkel 10 abgewinkelte Federschenkel 11 greift im eingesetzten Zustand durch eine weitere Öffnung 16 im Elektronikträger 3 hindurch und kontaktiert damit einen Boden des Gehäuses 1. An dem Federschenkel 11 ist ein Spannarm 17 angebracht, der einen Spannschenkel 18 und einen Kontaktschenkel 19 aufweist, wobei der Kontaktschenkel 19 bei eingesetzter Verriegelungsfeder 5 gegen die Leiterbahnplatte drückt und damit den Federschenkel 11 gegen den Boden des Gehäuses 1.

Der Haltearm 14 und der Spannarm 17 sind einstückig durch Teilausstanzung an der Verriegelungsfeder 5 angebracht.

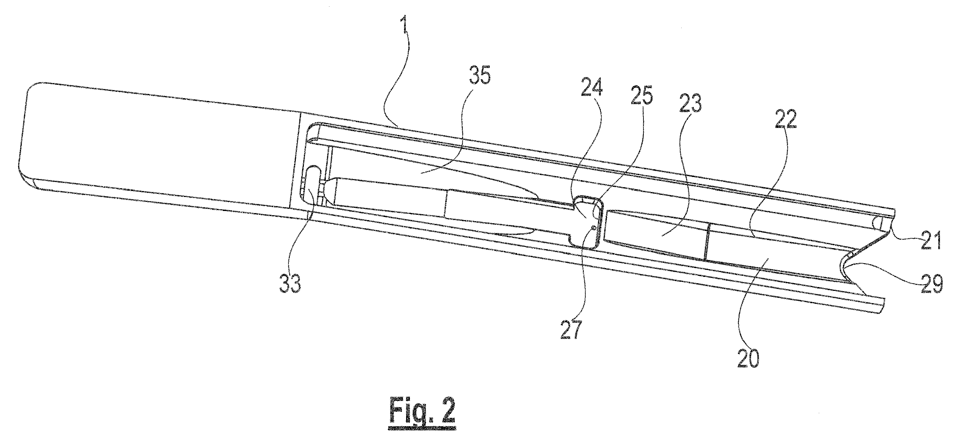

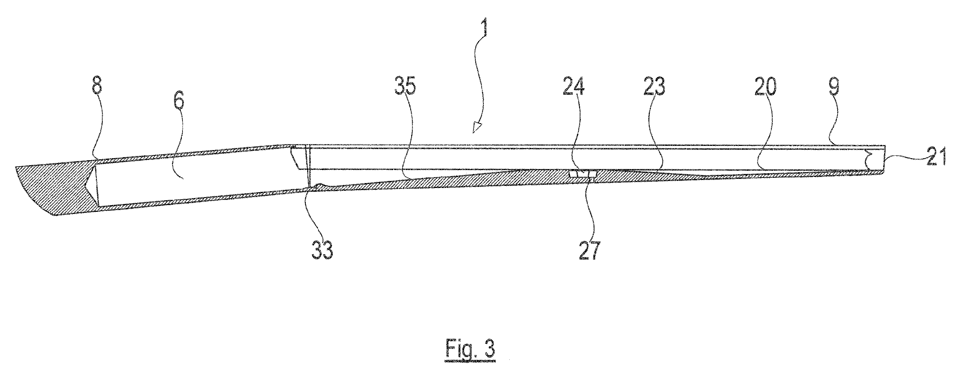

Die Ausbildung des Gehäuses ist am besten aus den Figuren 2 und 3 zu erkennen. Am Boden 20 des Gehäuses ist ausgehend von einem Einführende 21 ein ebener Abschnitt vorhanden, an den sich eine demgegenüber geneigte Rampe 23 anschließt, an deren Ende eine Vertiefung 24 vorhanden ist. Eine an die Rampe 23 anschließende, zur Vertiefung 24 führende Rastkante 25 ist gegenüber einer vertikalen Ebene um einen Winkel geneigt. Diese vertikale Ebene steht senkrecht zur Ebene der Leiterbahnplatte 2. Dieser Winkel beträgt ca. 10°. Die Vertiefung 24 ist gegenüber der Verriegelungsfeder 5 und der Ausnehmung 16 so angeordnet, dass bei vollständig in das Gehäuse 1 eingeschobenem Elektronikträger 3 der Rastschenkel 12 der Verriegelungsfeder 4 in die Vertiefung 24 eingreift, wobei der Rastschenkel 12 an der Rastkante 25 anliegt. Durch den Spannarm 17 wird der Federschenkel 11 federelastisch vorgespannt.

Im Boden der Vertiefung 24 ist eine kleine Öffnung 27 vorgesehen, die einen Durchmesser von wenigen Millimetern hat und damit beispielsweise an eine Nähnadel oder eine Büroklammer angepasst ist. Durch die Öffnung 27 kann man also mit dem genannten Gegenstand gegen den Federschenkel 11 drücken und diesen dabei so weit anheben, dass er über die Rastkante 25 abgehoben wird. Damit kann der Elektronikträger 3 ganz oder teilweise aus dem Gehäuse linear herausgeschoben werden.

Die Rundung 13 am Rastschenkel 12 gleitet dabei längs der Rampe 23 und anschließend längs des ebenen Abschnittes 22.

Beim Einschieben des Elektronikträger gleitet die Rundung 13 die Rampe 23 hinauf und spannt den Federschenkel 11, wodurch sich eine linear zunehmende Kraft ergibt, die der Benutzer haptisch führt, bis der Rastschenkel 12 in die Vertiefung 24 einrastet, was ebenfalls haptisch und akustisch wahrnehmbar ist.

Die kleine Öffnung 27 ist für uninformierte Benutzer (fast) nicht erkennbar, so dass sie die Fernsteuerung nicht öffnen und die Batterien nicht entnehmen können.

In Einschieberichtung ist zusätzlich eine Begrenzung vorgesehen, indem am Elektronikträger 3 ein Vorsprung 28 vorgesehen ist, der etwa dreieckförmig ausgebildet ist und in Richtung zum Boden des Gehäuses vorspringt. Eine entsprechende Ausnehmung 29 am Ende 21 des Gehäuses dient als Gegenanschlag. Damit ist der Elektronikträger bei eingerasteter Verriegelungsfeder 5 fest im Gehäuse 1 fixiert.

Zum Auswechseln der Batterien ist es lediglich erforderlich, den Elektronikträger 3 so weit aus dem Gehäuse 1 heraus zu ziehen, dass der Batterieträger 4 vollständig aus der Sacklochausnehmung herausgenommen werden kann. Um ein vollständiges Herausnehmen des Elektronikträgers 3 aus dem Gehäuse 1 zu verhindern, ist eine weitere Feder 30 vorgegehen, die zwischen der Leiterbahnplatte 2 und dem Elektronikträger 3 gehalten ist und durch eine Öffnung 31 vorsteht. Diese Feder rastet beim Herausziehen des Elektronikträgers 3 in die Vertiefung 24 ein und begrenzt damit den Verschiebeweg des Elektronikträgers 3 gegenüber dem Gehäuse 1. Zum vollständigen Herausnehmen des Elektronikträgers 3 kann auch diese Feder 30 durch eine in die Öffnung 27 eingeführte Nadel oder sonstigen Gegenstand zurückgedrückt werden.

Ist der Elektronikträger 3 so weit aus dem Gehäuse 1 herausgeschoben, dass die weitere Feder 30 in die Vertiefung 24 eingreift, so kann der Batterieträger 4 aus der Sacklochöffnung 6 herausgezogen werden. Zur Halterung des Batterieträgers 4 hat dieser einen federnden Rastarm 32, der in eine Vertiefung 33 oder eine dort vorgesehene Rastkante eingreift und damit den Batterieträger 4 in seiner Position hält. Zum Entnehmen wird dieser Rastarm 32 von Hand angehoben. Der Boden des Gehäuses 1 hat ausgehend vom Boden der Sacklochausnehmung 6 bis in die Nähe der Vertiefung eine durchgehende gerade Fläche 35, die unter dem genannten Winkel α geneigt ist, so dass der Batterieträger 4 geradlinig herausgebogen werden kann.

Der Batterieträger 4 ist an seinem der Leiterbahnplatte 2 abgewandten Ende durch eine Feder 33 in der Sacklochöffnung 6 abgestützt an seinem anderen der Leiterbahnplatte 2 zugewandten Seite durch den federelastischen Rastarm 34 gehalten. Somit ist der Batterieträger 4 insgesamt geringfügig federnd im Gehäuse 1 gelagert, während die am Elektronikträger 3 fest fixierte Leiterbahnplatte 2 gegenüber dem Gehäuse 1 in der normalein Betriebsstellung starr gehalten ist. Hieraus ergibt sich als Folgeproblem, dass bei den üblicherweise verwendeten Batterieträgern mit in Axialrichtung der Batterien wirkenden Kontakten die Kontaktkraft und damit der Übergangswiderstand schwankt. Zur Lösung dieses Folgeproblems sind am Batterieträger Kontakte 34 angebracht, die mit Kontaktflächen 35 der Leiterbahnplatte 2 in Berührung kommen, und zwar so, dass eine senkrecht zur Ebene des Elektronikträgers 3 und der Leiterbahnplatte 2 wirkende Kraft austritt. Damit ist die Kontaktkraft zwischen den Kontaktarmen 34 und den Kontakten 35 stets konstant und unabhängig von einer möglichen Positionsänderung des Batterieträgers. Vielmehr können die Kontaktarme 34 bei einer solchen Bewegung längs der Kontakt 35 gleiten und damit sogar eine Reinigungswirkung hervorrufen.

## Patentansprüche

1. Fernsteuerung mit einem Gehäuse (1), einem in einer Sacklochausnehmung (6) des Gehäuses (1) angeordneten Batterieträger (4) und einem Elektronikträger, der mit einer Leiterbahnplatte verbunden ist, **dadurch gekennzeichnet,**
**dass** der Elektronikträger (3) parallel zur Ebene der Leiterbahnplatte (2) gegenüber dem Gehäuse (1) linear verschiebbar angeordnet ist,
**dass** zwischen der Leiterbahnplatte (2) und dem Elektronikträger (3) eine Verriegelungsfeder (5) angeordnet ist, die mit einem Halteschenkel (10) zwischen der Leiterbahnplatte (2) und dem Elektronikträger (3) gehalten ist und mit einem gegenüber dem Halteschenkel (10) abgewinkelten Federschenkel (11) durch eine Öffnung (13) des Elektronikträgers (3) hindurchgreift, wobei der Federschenkel gegen einen Boden (20) des Gehäuses federelastisch anliegt,
**dass** an dem Federschenkel (11) ein Rastschenkel (12) angebracht ist, der von dem Federschenkel (11) absteht,
**dass** am Boden (20) des Gehäuses (1) eine Rampe (23) angeordnet ist, die bis zu einer Vertiefung (24) ansteigt, wobei die Vertiefung (24) eine Rastkante (27) aufweist, mit der der Rastschenkel (12) in Kontakt bringbar ist, und
**dass** der Elektronikträger (3) gegenüber dem Gehäuse (1) mindestens soweit linear verschiebbar ist, dass der Batterieträger aus der Sacklochausnehmung (6) herausnehmbar ist.

2. Fernsteuerung nach Anspruch 1, **dadurch gekennzeichnet,**
**dass** an dem Federschenkel (11) ein Spannarm (17) einstückig angebracht ist, der mit einem Kontaktschenkel (19) an der Leiterbahnplatte (2) oder an einem von der Leiterbahnplatte (2) abstehenden Pfosten (39) in Kontakt ist.

3. Fernsteuerung nach Anspruch 1 oder 2, **dadurch gekennzeichnet,**
dassan dem Halteschenkel (10) ein Haltearm (14) einstückig angebracht ist, der gegenüber dem Halteschenkel (10) abgewinkelt ist und damit eine Aussparung (38) in dem Halteschenkel (10) bildet und dass an der Leiterbahnplatte (2) ein Pfosten (37) angebracht ist, der in die Ausnehmung (38) eingreift.

4. Fernsteuerung nach einem der Ansprüche 1 bis 3, **dadurch gekennzeichnet,**
**dass** der Rastschenkel (12) der Verriegelungsfeder (5) und die Rastkante (25) gegenüber einer vertikalen Ebene auf die Ebene der Leiterbahnplatte unter einem Winkel von ca. 10° geneigt sind.

5. Fernsteuerung nach einem der Ansprüche 1 bis 4, **dadurch gekennzeichnet, dass** der Rastschenkel (12) über eine Rundung (13) mit dem Federschenkel (11) verbunden ist.

6. Fernsteuerung nach einem der Ansprüche 1 bis 5, **dadurch gekennzeichnet,**
**dass** zwischen der Leiterbahnplatte (2) und dem Elektronikträger (3) eine zweite Feder (30) angeordnet ist, die durch eine Öffnung (31) des Elektronikträgers (3) hindurchgreift und gegenüber der Verriegelungsfeder (5) in Längsrichtung um einen Verschiebeweg versetzt angeordnet ist, der mindestens der Lange des Batterieträgers (4) entspricht,
wobei die weitere Feder (30) mit der Rastkante (25) der Ausnehmung (24) des Gehäuses (1) in Kontakt bringbar ist.

7. Fernsteuerung nach einem der Ansprüche 1 bis 6, **dadurch gekennzeichnet,**
**dass** der in der Sacklochausnehmung (6) des Gehäuses (3) angeordnete Batterieträger (4) mit einer Feder (33) am Boden der Sacklochausnehmung (6) abgestützt ist und mit einer Haltefeder (32), die der Feder (33) gegenüberliegt, in eine weitere Vertiefung (33) am Boden des Gehäuses (1) eingreift.

8. Fernsteuerung nach Anspruch 7, **dadurch gekennzeichnet,**
**dass** ein die Sacklochausnehmung (6) aufweisender Batterieteil (8) des Gehäuses gegenüber einem den Elektronikträger (3) aufnehmenden Elektronikteil (9) des Gehäuses um einen Winkel (α) von ca. 175° abgewickelt ist.

9. Fernsteuerung nach Anspruch 8, **dadurch gekennzeichnet,**
**dass** der Boden des Gehäuses (1) ausgehend von der Sacklochausnehmung (6) eine Schräge (35) aufweist, deren Länge mindestens der Länge des Batterieträgers (4) entspricht.

10. Fernsteuerung nach einem der Ansprüche 1 bis 9, **dadurch gekennzeichnet,**
**dass** am Elektronikträger (3) ein Vorsprung (28) angebracht ist, der in eine Ausnehmung (29) an dem dem Batterieteil (8) des Gehäuses entgegengesetzt angeordneten Ende (21) des Gehäuses (1) angeordnete Ausnehmung (29) in Anschlag bringbar ist.

11. Fernsteuerung nach einem der Ansprüche 1 bis 10, **dadurch gekennzeichnet,**
**dass** im Boden des Gehäuses (1) im Bereich der Ausnehmung (24) eine Öffnung (27) gegenüberliegend zu dem Federschenkel (11) angeordnet ist, wobei der Durchmesser der Öffnung (27) in der Größenordnung von 1 bis 2 mm liegt.

## Claims

1. A remote control having a housing (1), a battery carrier (4) arranged in a blind hole recess (6) of the housing (1), and an electronics carrier which is connected to a conductor board, **characterized in that**
the electronics carrier (3) is arranged so as to be linearly displaceable relative to the housing (1) parallel to the plane of the conductor board (2),between the conductor board (2) and the electronics carrier (3) is arranged a locking spring (5) which is held between the conductor board (2) and the electronics carrier (3) with a holding leg (10) and reaches through an opening (13) of the electronics carrier (3) with a spring leg (11) that is angled relative to the holding leg (10), with the spring leg bearing springily against a bottom (20) of the housing,
there is attached to the spring leg (11) a snap-in leg (12) which protrudes from the spring leg (11),
there is arranged on the bottom (20) of the housing (1) a ramp (23) which rises up to a depression (24), with the depression (24) having a snap-in edge (27) with which the snap-in leg (12) is adapted to be brought in contact, and
the electronics carrier (3) is linearly displaceable relative to the housing (1) at least to the extent that the battery carrier is removable from the blind hole recess (6).

2. The remote control according to claim 1, **characterized in that** there is integrally attached to the spring leg (11) a tensioning arm (17) which is in contact with a contact leg (19) on the conductor board (2) or on a post (39) protruding from the conductor board (2).

3. The remote control according to claim 1 or 2, **characterized in that** there is integrally attached to the holding leg (10) a holding arm (14) which is angled relative to the holding leg (10) and forms therewith a recess (38) in the holding leg (10), and that there is attached to the conductor board (2) a post (37) which engages the recess (38).

4. The remote control according to any of claims 1 to 3, **characterized in that** the snap-in leg (12) of the locking spring (5) and the snap-in edge (25) are inclined at an angle of approx. 10° relative to a vertical plane perpendicular to the plane of the conductor board.

5. The remote control according to any of claims 1 to 4, **characterized in that** the snap-in leg (12) is connected to the spring leg (11) via a rounded area (13).

6. The remote control according to any of claims 1 to 5, **characterized in that** between the conductor board (2) and the electronics carrier (3) there is arranged a second spring (30) which reaches through an opening (31) of the electronics carrier (3) and is arranged offset from the locking spring (5) in the longitudinal direction by a displacement path which corresponds at least to the length of the battery carrier (4), with the further spring (30) being adapted to be brought in contact with the snap-in edge (25) of the recess (24) of the housing (1).

7. The remote control according to any of claims 1 to 6, **characterized in that** the battery carrier (4) arranged in the blind hole recess (6) of the housing (3) is supported on the bottom of the blind hole opening (6) with a spring (33) and engages a further depression (33) on the bottom of the housing (1) with a holding spring (32) located opposite the spring (33).

8. The remote control according to claim 7, **characterized in that** a battery section (8) of the housing, which has the blind hole recess (6), is angled by an angle (α) of approx. 175° relative to an electronics section (9) of the housing, which receives the electronics carrier (3).

9. The remote control according to claim 8, **characterized in that** the bottom of the housing (1) has, starting out from the blind hole recess (6), a sloping surface (35) whose length corresponds to at least the length of the battery carrier (4).

10. The remote control according to any of claims 1 to 9, **characterized in that** there is attached to the electronics carrier (3) a projection (28) which is adapted to be brought into abutment in a recess (29) arranged at the end (21) of the housing (1) that is arranged opposite the battery section (8) of the housing.

11. The remote control according to any of claims 1 to 10, **characterized in that** there is arranged in the bottom of the housing (1) in the region of the recess (24) an opening (27) opposingly to the spring leg (11), with the diameter of the opening (27) being in the order of magnitude of 1 to 2 mm.

## Revendications

1. Télécommande ayant un boîtier (1), un support de batterie (4) prévu dans un évidement borgne (6) du boîtier (1), et un support d'électronique, lequel est lié avec une plaque de câblage, **caractérisée**
**en ce que** le support d'électronique (3) est agencé de façon mobile linéairement par rapport au boîtier (1), parallèlement au plan de la plaque de câblage (2)
**en ce qu'**un ressort de verrouillage (5) est agencé entre la plaque de câblage (2) et le support d'électronique (3), lequel ressort est tenu avec une patte de maintien (10) entre la plaque de câblage (2) et le support d'électronique (3) et s'engage à travers une ouverture (13) du support d'électronique (3) avec une patte de ressort (11) angulée par rapport à la patte de maintien (10), de sorte que la patte de ressort vienne en appui élastique contre un fond (20) du boîtier,
**en ce que** sur la patte de ressort (11) est montée une patte d'encliquetage (12), laquelle fait saillie de la patte de ressort (11),
**en ce qu'**une rampe (23) est prévue sur le fond (20) du boîtier (1), laquelle rampe s'élève jusqu'à une cavité (24), ladite cavité (24) ayant un bord d'accrochage (27) pouvant entrer en contact avec la patte d'encliquetage (12), et
**en ce que** le support d'électronique (3) est déplaçable au moins de façon linéaire par rapport au boîtier (1), de façon que le support de batterie soit amovible hors de l'évidement borgne (6).

2. Télécommande selon la revendication 1, **caractérisée**
**en ce qu'**un bras de tension (17) est monté intégralement sur la patte de ressort (11), lequel bras de tension est en contact avec une patte de contact (19) sur la plaque de câblage (2) ou avec un ergot (39) en saillie de la plaque de câblage (2).

3. Télécommande selon la revendication 1 ou 2, **caractérisée en ce qu'**un bras de retenue (14) est monté intégralement sur la patte de maintien (10), lequel bras de retenue est orienté angulairement par rapport à la patte de maintien (10) et forme ainsi un logement (38) dans la patte de maintien (10) et **en ce qu'**un ergot (37) est prévu sur la plaque de câblage (2), lequel ergot s'engage dans le logement (38).

4. Télécommande selon l'une des revendications 1 à 3, **caractérisée en ce que** la patte d'encliquetage (12) du ressort de verrouillage (5) et le bord d'accrochage (25) sont inclinés d'un angle d'environ 10° par rapport à un plan vertical par rapport au plan de la plaque de câblage.

5. Télécommande selon l'une des revendications 1 à 4, **caractérisée en ce que** la patte d'encliquetage (12) est raccordée à la patte de ressort (11) par un arrondi (13).

6. Télécommande selon l'une des revendications 1 à 5, **caractérisée en ce qu'**un second ressort (30) est disposé entre la plaque de câblage (2) et le support d'électronique (3), lequel ressort traverse une ouverture (31) du support d'électronique (3) et est décalé par rapport au ressort de verrouillage (5) selon un chemin de déplacement longitudinal d'au moins la longueur du support de batterie (4), de sorte que le ressort supplémentaire (30) peut entrer en contact avec le bord d'accrochage (25) de la cavité (24) du boîtier (1).

7. Télécommande selon l'une des revendications 1 à 6, **caractérisée en ce que** le support de batterie (4) disposé dans l'évidement borgne (6) du boîtier (3) est soutenu par un ressort (33) dans le fond de l'évidement borgne (6) et est engagé par un ressort de maintien (32) en opposition au ressort (33) dans un évidement supplémentaire (33) dans le fond du boîtier (1).

8. Télécommande selon la revendication 7, **caractérisée en ce qu'**un pack de batterie (8) du boîtier comportant l'évidement borgne (6) fait un angle (α) d'environ 175° avec une partie électronique (9) du boîtier qui reçoit le support d'électronique (3).

9. Télécommande selon la revendication 8, **caractérisée en ce que** le fond du boîtier (1) comprend un biais (35) à partir de l'évidement borgne (6), dont la longueur correspond à au moins la longueur du support de batterie (4).

10. Télécommande selon l'une des revendications 1 à 9, **caractérisée en ce qu'**une projection (28) est attachée au support d'électronique (3), laquelle peut être amenée en butée dans un logement (29) prévu à l'extrémité (21) du boîtier (1) qui est opposée au pack de batterie (8) du boîtier.

11. Télécommande selon l'une des revendications 1 à 10, **caractérisée en ce que** le fond du boîtier (1) dans la région du logement (24) comprend une ouverture (27) opposée à la patte de ressort (11), dans laquelle le diamètre de l'ouverture (27) est compris entre 1 et 2 mm.
